# EUROPÄISCHE PATENTSCHRIFT

(11) **EP 1 502 310 B1**
(45) Veröffentlichungstag und Bekanntmachung des Hinweises auf die Patenterteilung: **12.11.2008**
(21) Anmeldenummer: 03737871.8
(22) Anmeldetag: 06.05.2003
(51) Int. Cl.: H01L 41/083

(54) **PIEZOAKTOR UND VERFAHREN ZU DESSEN HERSTELLUNG**
PIEZOACTUATOR AND METHOD FOR THE PRODUCTION THEREOF
PIEZOACTIONNEUR ET SON PROCEDE DE PRODUCTION

(30) Priorität: 06.05.2002 DE 10220136; 23.01.2003 DE 10302600
(43) Veröffentlichungstag der Anmeldung: 02.02.2005
(73) Patentinhaber: EPCOS AG, 81669 München (DE)
(72) Erfinder: FLORIAN, Heinz, A-8524 Bad Gams (AT); REICHMANN, Klaus, A-8042 Graz (AT); KAINZ, Gerald, A-8010 Graz (AT)
(74) Vertreter: Epping - Hermann - Fischer
(86) Internationale Anmeldenummer: PCT/DE2003/001451
(87) Internationale Veröffentlichungsnummer: WO 2003/094252

(56) Entgegenhaltungen:
- WO-A-02/19441
- DE-A- 19 909 482
- US-A- 4 471 256
- PATENT ABSTRACTS OF JAPAN vol. 014, no. 467 (E-0989), 11. Oktober 1990 (1990-10-11) & JP 02 192186 A (TOTO LTD), 27. Juli 1990 (1990-07-27) -& JP 02 192186 A (TOTO LTD) 27. Juli 1990 (1990-07-27)
- PATENT ABSTRACTS OF JAPAN vol. 016, no. 288 (E-1223), 25. Juni 1992 (1992-06-25) & JP 04 073978 A (TOYOTA MOTOR CORP), 9. März 1992 (1992-03-09) -& JP 04 073978 A (TOYOTA MOTOR CORP) 9. März 1992 (1992-03-09)

## Beschreibung

Die Erfindung betrifft einen Piezoaktor mit übereinanderliegenden piezoelektrischen Schichten und dazwischenliegenden Elektrodenschichten. Darüber hinaus betrifft die Erfindung ein Verfahren zur Herstellung des Piezoaktors.

Aus der Druckschrift DE 100 24 701 A1 ist ein Piezoaktor bekannt, der in einem Mehrschichtaufbau Piezolagen und zwischen diesen Lagen angeordnete Innenelektroden enthält. Die Innenelektroden sind wechselseitig mit äußeren Anschlußkontakten kontaktiert. Die jeweils zusammengehörigen Innenelektroden sind mit zu den jeweils anderen Innenelektroden isoliert angeordneten Funktionselementen, die Durchkontaktierungen bilden in den Piezolagen elektrisch miteinander verbunden. Dadurch wird eine Kontaktierung der Elektrodenschichten des Piezoaktors auf der Innenseite des Aktors realisiert. Die Durchkontaktierungen innerhalb der Piezolagen sind mit Hilfe der bekannten Via-Technik realisiert, wie sie beispielsweise aus dem Aufbau von LTCC-Substraten bekannt ist. Dabei werden in die zur Herstellung des Piezoaktors verwendeten keramischen Grünfolien Löcher gestanzt, die anschließend mit einer sogenannten Via-Fill-Paste gefüllt und dann zusammen mit den Grünfolien gesintert werden.

Der bekannte Piezoaktor hat den Nachteil, daß die Anordnung eines Funktionselements zur Kontaktierung der inneren Elektrodenschichten aufwendig in der Herstellung ist da eine Vielzahl von Löchern erzeugt werden muß. Der Piezoaktor hat ferner den Nachteil, daß die mit Hilfe der Via-Fill-Technik hergestellten inneren Funktionselemente neben der Kontaktierung der Elektrodenschichten keine weitere Funktion übernehmen können, da sie ihre mechanischen Eigenschaften erst während des Sinterns des Piezoaktors endgültig annehmen, was bedeutet, daß die zu Beginn des Herstellungsprozesses verwendete Via-Fill-Paste keine mechanische Stabilität besitzt, sondern diese erst im Laufe des Verfahrens, insbesondere während des Sinterns erhält.

Aus US 4,471,256 ist ein Piezoaktor bekannt, in dessen Grundkörper mehrere Elektrodenstäbe vorhanden sind, welche Elektrodenschichten kontaktieren.

Aus der Druckschrift DE 199 09 482 ist ferner ein Piezoaktor bekannt, bei dem ein Loch durch den Aktor verläuft. An der Innenwand des Lochs ist ein Elektrodenanschluß angeordnet, der der Kontaktierung der der Innenelektroden dient. Ferner ist ein metallischer Stift durch das Loch geführt, der zur Anbringung einer mechanischen Vorspannung vewendet wird.

Dieser Aktor hat den Nachteil, daß die Funktion Kontaktierung und die Funktion Vorspannungserzeugung voneinander getrennt sind und dementsprechend ein hoher fertigungstechnischer Aufwand für die Herstellung des Aktors notwendig ist.

Es ist daher Aufgabe der vorliegenden Erfindung, einen Piezoaktor bereitzustellen, bei dem innerhalb des Piezoaktors ein Funktionselement angeordnet ist, welcher leicht herstellbar ist und bei dem das Funktionselement verschiedene Funktionen übernehmen kann.

Diese Aufgabe wird gelöst durch einen Piezoaktor gemäß Patentanspruch 1. Vorteilhafte Ausgestaltungen des Piezoaktors sowie ein Verfahren zur Herstellung des Piezoaktors sind den weiteren Patentansprüchen zu entnehmen.

Es wird ein Piezoaktor angegeben, mit einem Grundkörper, der einen Stapel von übereinanderliegenden piezoelektrischen Schichten und dazwischenliegenden Elektrodenschichten enthält. Die piezoelektrischen Schichten enthalten Keramikmaterial und sind mit den Elektrodenschichten versintert. In den Elektrodenschichten verläuft ein Loch durch den Grundkörper.

In das Loch ist ein vorgeformtes Kontaktelement zur Kontaktierung der Elektrodenschichten eingeschoben.

Der Piezoaktor hat den Vorteil, daß das vorgeformte Kontaktelement als Funktionselement auf einfache Art und Weise in das Innere des Grundkörpers eingebracht werden kann. Der Piezoaktor hat ferner den Vorteil, daß das Funktionselement aufgrund seiner vorgegebenen Form und aufgrund seiner mechanischen Stabilität mehrere Funktionen übernehmen kann.

Vorteilhafterweise steht das Kontaktelement direkt mit Elektrodenschichten in elektrischem Kontakt.

Es ist dabei von Vorteil, wenn das vorgeformte Kontaktelement ein Stift ist, der aus einem Material besteht, das stabil ist gegenüber den beim Sintern des Piezoaktors auftretenden Temperaturen, der also insbesondere nicht wie die für die Elektrodenschichten und Durchführungen üblicherweise verwendeten metallhaltigen Pasten einem Sinterschwund unterliegt. Ein solcher formstabiler Stift zeichnet sich durch gleichbleibende mechanische Eigenschaften aus, die es ermöglichen, den Stift zur Klemmung des Piezoaktors zu verwenden.

Die Erfindung beschränkt sich jedoch nicht auf ein vorgeformtes Kontaktelement in Form eines Stiftes sondern betrifft alle Kontaktelemente, die vorgeformt sind und in ein Loch im Grundkörper eingeschoben werden können. Dementsprechend sind die folgenden Ausführungsformen, obwohl nur in Bezug auf einen Stift beschrieben, entsprechend auch auf andere Formen des vorgeformten Kontaktelements anwendbar.

Es wird darüber hinaus ein Verfahren zur Herstellung des Piezoaktors angegeben, wobei folgende Schritte zur Anwendung kommen:
a) Bilden eines Schichtstapels aus übereinanderliegenden keramischen Grünfolien und dazwischenliegenden Elektrodenschichten
b) Bohren eines Lochs in den Schichtstapel
c) Einschieben eines vorgeformten Kontaktelements in das Loch.

Das Verfahren hat den Vorteil, daß es auf einfache Art und Weise, nämlich durch Bohren eines einzigen Loches gelingt, das Funktionselement, vorzugsweise einen Stift, in das Innere des Piezoaktors einzubringen.

Der Stift im Innern des Piezoaktors kann beispielsweise dazu verwendet werden, Elektrodenschichten innerhalb des Piezoaktor zu kontaktieren. Dies gelingt insbesondere dadurch, daß der Stift aus einem elektrisch leitfähigen Material, beispielsweise aus Metall besteht.

Der Stift kann in einer ersten Ausführungsform der Erfindung vor dem Entkohlen und vor dem Sintern in den Schichtstapel eingeschoben werden. Dann ist es vorteilhaft, die Abmessungen des Lochs so auf die Abmessungen des Stifts abzustimmen, daß nach dem Sintern des Schichtstapels durch den Schrumpf der in den piezoelektrischen Schichten enthaltenen Keramik diese gewissermaßen auf den Stift aufschrumpft und somit die elektrische Kontaktierung des Stifts mit Elektrodenschichten ermöglicht.

Es ist dabei im weiteren vorteilhaft, wenn der Stift wenigstens auf seiner Oberfläche zu wenigstens 50 % aus demselben Material besteht, aus dem auch die Elektrodenschichten gebildet sind. Dies gewährleistet eine relativ gute chemische Anbindung des Stifts an die Elektrodenschichten, was den elektrischen Kontakt zwischen dem Stift und Elektrodenschichten verbessert.

In einer weiteren Ausführungsform der Erfindung kann der Stift beziehungsweise die Bildung des Lochs nach dem Entkohlen und Sintern des Schichtstapels durchgeführt werden. In diesem Fall, wenn also der Stift wiederum zur Kontaktierung der Elektrodenschichten verwendet werden soll, ist es vorteilhaft, wenn die Abmessungen des Lochs und des Stifts so aufeinander abgestimmt sind, daß im gesinterten Zustand des Schichtstapels der Stift noch durch das Loch geschoben werden kann, also ein gewisser Mindestspielraum zwischen der Innenwand des Schichtstapels und der Außenwand des Stifts vorhanden ist. Um zu einer sicheren Kontaktierung zu kommen, ist es dann vorteilhaft, beispielsweise den Stift auf seiner Außenseite mit Graphit oder einem anderen elektrisch leitfähigen Gleitmittel zu versehen, welches es ermöglicht, die zum Einschieben des Stifts benötigten Zwischenräume aufzufüllen und für eine gute Kontaktierung zwischen Stift und Elektrodenschicht zu sorgen.

Falls das Loch in den Schichtstapel gebohrt wird, bevor die Schritte des Entkohlens und des Sinterns erfolgen, ist es vorteilhaft, wenn das Loch mittels eines Hartmetallbohrers gebohrt wird, da so ein möglichst sauberes und gradlinig verlaufendes Loch erzeugt werden kann, was wichtig ist, um später nach dem Sintern einen elektrischen Kontakt zwischen den Elektrodenschichten und dem Stift zu gewährleisten.

Desweiteren kann der Stift auch zur Herstellung einer mechanischen Klemmung für den Piezoaktor dienen. Bekanntermaßen ist es vorteilhaft, einen Piezoaktor in Längsrichtung vorzuspannen, um ihn optimal als in diese Längsrichtung eine Ausdehnung erzeugenden Aktor benutzen zu können. Eine Vorspannung kann mittels des Stifts hergestellt werden, indem es ausgenutzt wird, daß das Keramikmaterial des Schichtstapels beim Sintern schrumpft. Durch geeignete Abmessungen von Loch und Stift sowie Aufschrumpfen des Keramikmaterials auf den Stift kann somit eine formschlüssige beziehungsweise kraftschlüssige Verbindung zwischen Stift und Piezoaktor hergestellt werden. Hierzu ist es insbesondere erforderlich, geeignete Abmessungen von Loch und Stift einerseits und geeignete Materialien für den Stift anderseits, nämlich ein formstabiles Material, welches beim Sintern keinen Schwund aufweist, zu verwenden.

Eine formschlüssige Verbindung ist im allgemeinen notwendig für die Herstellung des elektrischen Kontakts zwischen dem Stift und Elektrodenschichten.

Die kraftschlüssige Verbindung zwischen dem Stift und dem Schichtstapel ist erforderlich, wenn der Stift zur mechanischen Klemmung des Piezoaktors dienen soll. Eine mechanische Vorspannung erreicht man, indem ein Stift gewählt wird, dessen Wärmeausdehnungskoeffizient größer ist als der Wärmeausdehnungskoeffizient der gesinterten Keramik. Der Stift wird vor dem Sintern der Keramik in das Loch eingeschoben, und nach dem anschließenden Sintern wird der Piezoaktor auf Zimmertemperatur abgekühlt. Der kraftschlüssig mit dem Piezoaktor verbundene Stift zieht sich stärker zusammen als der Piezoaktor selbst, und der Stift steht gegenüber dem Grundkörper des Piezoaktors unter Zugspannung und verleiht dem Piezoaktor die erforderliche mechanische Klemmung.

Die Herstellung einer mechanischen Klemmung für den Piezoaktor kann aber mittels des Stiftes auch noch auf anderem Wege erzeugt werden. Hierzu ist es möglich, den Stift erst nach dem Sintern des Piezoaktors in das Loch einzuschieben. Anschließend wird der Piezoaktor zwischen zwei Platten eingespannt, die sich an der Grund- beziehungsweise an der Deckfläche des Schichtstapels befinden. Während des mechanischen Drucks, der die beiden Platten zusammendrückt, wird nun der im Innern des Piezoaktors verlaufende Stift an den Platten befestigt, wodurch auch nach Wegnahme der äußeren mechanischen Spannung der Piezoaktor unter einer mechanischen Vorspannung steht.

Es ist darüber hinaus auch denkbar, den Stift in Form einer Torsionsfeder auszuführen. Eine solche Torsionsfeder erhält man beispielsweise, indem man den Stift als miteinander verseilte Stahlfasern ausführt. Hier kann nun die mechanische Vorspannung des Piezoaktors erzeugt werden, indem der Stift auf der Oberseite und auf der Unterseite des Schichtstapels jeweils mit an einer Platte befestigt wird und durch nachfolgendes Verdrehen der Platten eine Druckspannung in Längsrichtung des Piezoaktors aufgebaut werden kann.

In einer Ausführungsform der Erfindung sind mehrere Stifte innerhalb des Piezoaktors angeordnet. Beispielsweise können vier Stifte angeordnet sein, von denen zwei der elektrischen Kontaktierung mit den Elektrodenschichten und zwei weitere für die Herstellung der mechanischen Klemmung des Piezoaktors dienen.

In einer anderen Ausführungsform der Erfindung befindet sich das Loch entlang einer Längsmittelachse des Grundkörpers und es ist ein aus zwei halbrunden Teilstiften zusammengesetzter Stift in das Loch eingeführt. Die beiden Teilstifte sind durch eine keramikhaltige Folie voneinander elektrisch isoliert. Somit können die beiden Teilstifte die elektrische Kontaktierung der Elektrodenschichten mit zwei verschiedenen äußeren Polen des Piezoaktors realisieren.

Der aus zwei Teilstiften bestehende Stift oder auch ein einteiliger Stift kann bei entsprechenden Maßnahmen bezüglich Abmessungen des Lochs und Sinterung der Keramik gleichzeitig als Element zur Erzeugung der Vorspannung des Piezoaktors dienen. In diesem Fall hat diese Ausführungsform noch den Vorteil, daß die Vorspannung im Zentrum des Piezoaktors erzeugt wird, was einen symmetrischen Aufbau des Piezoaktors realisiert und beispielsweise Verkrümmungen des Piezoaktors, wie sie im Fall von an der Außenseite des Piezoaktors angeordneten Vorspannelementen häufig auftreten, vermeiden hilft.

Im folgenden wird die Erfindung anhand von Ausführungsbeispielen und den dazugehörigen Figuren näher erläutert.
- Figur 1: zeigt einen erfindungsgemäßen Piezoaktor in einer perspektivischen Darstellung.
- Figur 2: zeigt einen Piezoaktor in einem schematischen Längsschnitt.
- Figur 2a: zeigt den Kontaktbereich eines mittels eines elektrisch leitfähigen Gleitmittels kontaktierten Stifts.
- Figur 3: zeigt einen Piezoaktor in Draufsicht.
- Figur 4: zeigt einen Piezoaktor in einem schematischen Längsschnitt.
- Figur 5: zeigt eine als Stift verwendbare Litze in einer Draufsicht.
- Figur 6: zeigt die Kontaktierung von Elektrodenschichten mittels einer Litze gemäß Figur 5 in einem schematischen Querschnitt.

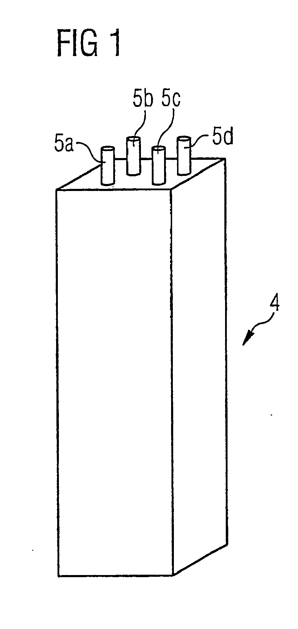

Figur 1 zeigt einen Piezoaktor mit einem Grundkörper 4, in den in Längsrichtung vier Löcher gebohrt sind. In jedem der Löcher sitzt ein Stift 5a, 5b, 5c, 5d.

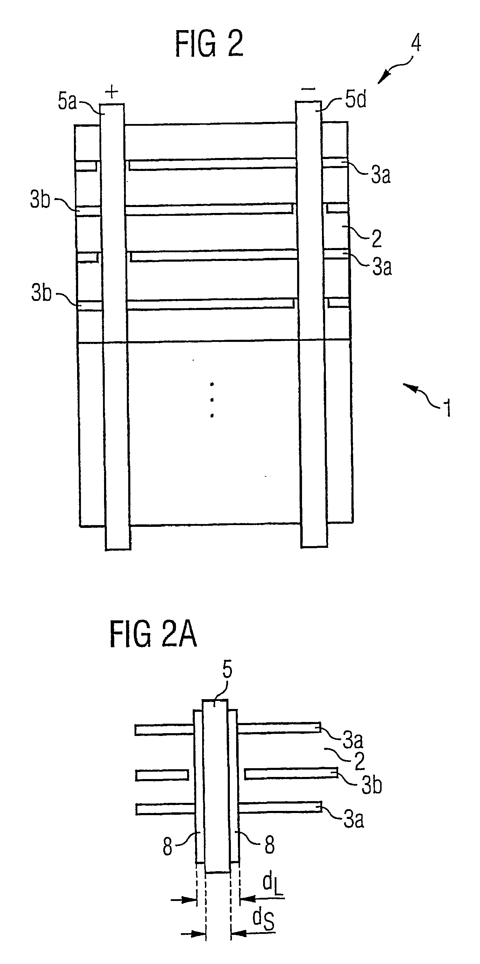

Figur 2 zeigt einen Piezoaktor mit zwei Stiften 5a, 5d. Er besteht aus einem Stapel 1 von übereinanderliegenden piezoelektrischen Schichten 2. Die piezoelektrischen Schichten 2 bestehen aus einer Piezokeramik, welche 67 Gew.-% Pb₃O₄, zirka 1 Gew.-% Nd₂O₃, 21 Gew.-% ZrO₂ und zirka 11 Gew.-% TiO₂ aufweist. Die Erfindung ist jedoch nicht auf eine solche Piezokeramik beschränkt, sondern kann mit sämtlichen piezoelektrischen Schichten 2 verwirklicht werden, die geeignete piezoelektrischen Eigenschaften aufweisen.

Der Stapel 1 weist Elektrodenschichten 3a, 3b auf, die übereinander liegen, wodurch sich die piezoelektrischen Effekte vieler piezoelektrischer Schichten 2 aufsummieren. Die Elektrodenschichten 3a, 3b bestehen aus einer Mischung von Silber und Palladium im Gewichtsverhältnis zwischen 90/10 und 70/30. Der Stapel 1 ist durch gemeinsames Sintern von Elektrodenschichten 3a, 3b und piezoelektrischen Schichten 2 hergestellt, weswegen als Elektrodenschichten 3a, 3b alle bei Sinterbedingungen stabile Metalle beziehungsweise Metallegierungen geeignet sind. So kommen insbesondere auch Elektrodenschichten 3a, 3b aus Kupfer in Betracht. Die jeweils zu einem Stift 5a, 5d gehörenden Elektrodenschichten 3a, 3b sind mit diesem elektrisch leitend verbunden.

Der Stapel 1 hat die Form eines Quaders mit einer Grundfläche von 7 x 7 mm. Er weist eine Höhe von 60 mm auf.

Darüber hinaus sind zwischen den piezoelektrischen Schichten 2 Elektrodenschichten 3a, 3b angeordnet. Die Elektrodenschichten 3a sind mit dem Stift 5b elektrisch kontaktiert. Die Elektrodenschichten 3b weisen an der Stelle des Stifts 5b Isolierzonen auf, weswegen die Elektrodenschichten 3b von dem Stift 5b elektrisch isoliert sind. Dafür sind die Elektrodenschichten 3b mit dem Stift 5a elektrisch kontaktiert. Da nun abwechselnd mit jeweils unterschiedlichen Polen kontaktierbare übereinanderliegende Elektrodenschichten 3a, 3b vorliegen, addiert sich der Effekt vieler piezoelektrischen Schichten 2.

Figur 2A zeigt die Kontaktzone eines Stifts 5, der den Kontakt zu den Elektrodenschichten 3a mittels eines elektrisch leitfähigen Gleitmittels 8 erzeugt. In diesem Fall ist die Abmessung des Lochs d_{L} größer als die Abmessung des Stift d_{S}, was es erlaubt, den Stift 5 auch nach dem Sintern des Schichtstapels 1 noch in das Loch einzuschieben. Um nun den Zwischenraum zwischen Stift und Innenwand des Piezoaktors zur Kontaktierung der Elektrodenschichten 3a aufzufüllen, wird auf der Oberfläche des Stiftes 5 ein elektrisch leitfähiges Gleitmittel 8, beispielsweise Graphit aufgetragen. Diese Graphitschicht vermittelt nun den elektrischen Kontakt zwischen den Elektrodenschichten 3a und dem Stift 5, der als Außenkontakt des Piezoaktors dienen kann.

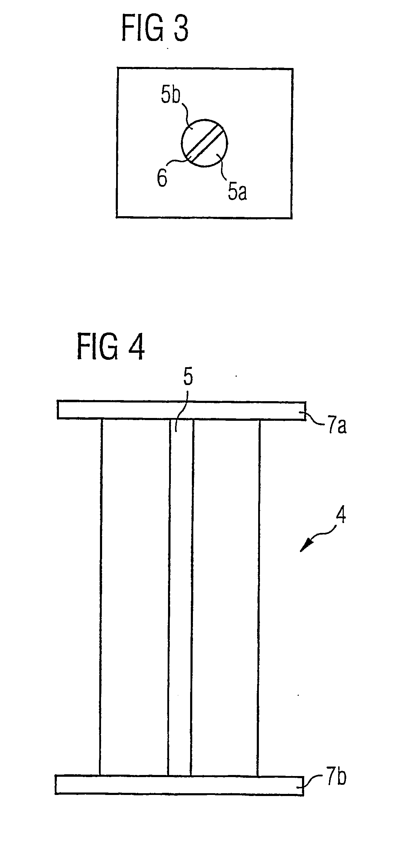

Figur 3 zeigt eine weitere Ausführungsform der Erfindung in Draufsicht, wobei ein zentrisches Loch in Längsrichtung des Piezoaktors gefüllt ist mit einem Stift, der aus zwei im Querschnitt halbkreisförmigen Teilstiften 5a und 5b gefertigt ist. Zwischen den beiden ebenen Begrenzungsflächen der Teilstifte 5a, 5b ist eine keramikhaltige Folie 6 aufgeklebt. Diese keramikhaltige Folie 6 besteht vorzugsweise aus derselben Keramik, aus der auch die piezoelektrischen Schichten 3 bestehen, um somit ein verbessertes Sinterverhalten zu ermöglichen. Die keramikhaltige Folie 6 bewirkt auch eine elektrische Isolierung der beiden Teilstifte 5a, 5b, weswegen in ähnlicher Art und Weise wie in Figur 2 gezeigt die elektrische Kontaktierung der Elektrodenschichten abwechselnd durch die Stifte 5a, 5b realisiert werden kann.

Figur 4 zeigt eine weitere Ausführungsform der Erfindung, wobei der Grundkörper 4 des Piezoaktors zwischen zwei Platten 7a und 7b eingeklemmt ist. Bei den Platten 7a und 7b sind am Stift 5 befestigt.

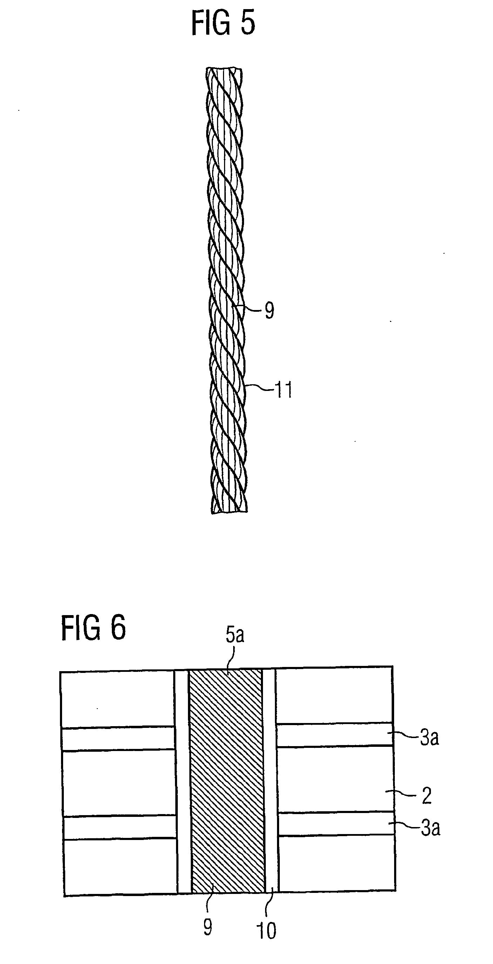

Figur 5 zeigt ein vorgeformtes Kontaktelement für den Piezoaktor, der eine innere Struktur aufweist. Eine innere Struktur kann vorteilhafterweise darin bestehen, daß das vorgeformte Kontaktelement eine Litze 9 ist, die aus mehreren Drähten 11 durch Verdrillen hergestellt ist.

Figur 5 zeigt eine Litze 9, die durch Verdrillen von Drähten 11 hergestellt ist und die als vorgeformtes Kontaktelement für die innere Kontaktierung der Innenelektroden eines Piezoaktors verwendet werden kann. Durch das Verdrillen von Drähten 11 erreicht die Litze 9 eine ausreichende mechanische Stabilität, um in ein Loch im Piezoaktor bzw. im Grundkörper des Piezoaktors eingeschoben zu werden. Um das Einschieben des vorgeformten Kontaktelements in Form einer Litze 9 noch weiter zu vereinfachen, kann es vorgesehen sein, daß die Litze 9 an einem ihrer Enden mechanisch stabilisiert ist. Eine solche mechanische Stabilisierung kann beispielsweise durch Crimpen oder auch durch mechanisches Verpressen erfolgen. Anstelle einer Litze 9 ist es auch möglich, ein Seil von Drähten zu verwenden. Daneben sind alle weiteren Aufbauarten von Litzen bzw. Seilen entsprechend der DIN 3051 denkbar. Insbesondere kommen auch Litzen in Betracht, die einfach verwürgt oder auch symmetrisch verwürgt sind. Dabei ist unter einer symmetrisch verwürgten Litze eine Litze zu verstehen, die neben einem zentralen Einlagedraht (Herzlitze) noch weitere, weiter außenliegende, entlang konzentrischer Kreise um die Herzlitze liegende Drähte aufweist. Dabei sind entlang eines ersten, innersten Kreises um die Herzlitze herum 6 Drähte und ggf. entlang eines darauffolgenden, größeren Kreises 12 und entlang weiterer Kreise 18, 24 usw. Drähte angeordnet. Es kommt darüber hinaus auch in Betracht, mehrere Litze zu einem dicken Seil zu verseilen.

Figur 6 zeigt die Kontaktierung von Elektrodenschichten 3a im Innern eines Piezoaktors mittels einer Litze 9, die die Funktion des vorgeformten Kontaktelements innehat. Zum Zwecke der Kontaktierung ist die Litze 9 auf der Außenseite mit einer elektrisch leitenden Beschichtung 10, beispielsweise einer metallhaltigen Einbrennpaste versehen. Besonders vorteilhaft ist es, für das Material der Beschichtung 10 wenigstens teilweise das Material zu verwenden, aus dem auch die Elektrodenschichten 3a hergestellt sind. Beispielsweise im Fall von Cu-Innenelektroden als Elektrodenschichten 3a ist es vorteilhaft, die Litze 9 mit einer Beschichtung 10 aus einer kupferhaltigen Einbrennpaste zu versehen. Dadurch sind die Materialien der Beschichtung 10 und der Elektrodenschichten 3a optimal aufeinander angepaßt, was den elektrischen Übergangswiderstand zwischen der Elektrodenschicht 3a und der Litze 9 reduzieren hilft.

Es kann darüber hinaus auch vorgesehen sein, die Litze 9 auch im Innern mit einer Paste bzw. dem Material der Beschichtung 10 zu versehen, um die einzelnen Drähte 11 der Litze 9 zusammenzukleben und somit die mechanische Stabilität der Litze 9 zu erhöhen, um somit das Einführen der Litze in das Loch des Grundkörpers zu verbessern.

### Bezugszeichenliste

- 1: Stapel
- 2: piezoelektrische Schicht
- 3a, b: Elektrodenschicht
- 4: Grundkörper
- 5a, 5b, 5c, 5d: Stift
- 6: keramikhaltige Folie
- 7a, 7b: Platte
- 8: elektrisch leitfähiges Gleitmittel
- 9: Litze
- 10: Beschichtung
- 11: Draht
- d_{L}: Abmessung des Lochs
- d_{S}: Abmessung des Stifts 5

## Patentansprüche

1. Piezoaktor
- mit einem Grundkörper, der einen Stapel (1) von übereinanderliegenden piezoelektrischen Schichten (2) und dazwischenliegenden Elektrodenschichten (3) enthält, bei dem die piezoelektrischen Schichten (2) Keramikmaterial enthalten und mit einander versintert sind,
- bei dem in den Elektrodenschichten (3a, 3b) ein Loch durch den Grundkörper (4) verläuft,
- in das ein vorgeformtes Kontaktelement (5a, 5b, 5c, 5d, 9) zur Kontaktierung der Elektrodenschichten (3a, 3b) eingeschoben ist, **dadurch gekennzeichnet, dass**
- das Kontaktelement aus einem formstabilen Material besteht, welches beim Sintern keinen Schwund aufweist.

2. Piezoaktor nach Anspruch 1,
bei dem das vorgeformte Kontaktelement ein Stift (5a, 5b, 5c, 5d) ist, welcher mit Elektrodenschichten (3a, 3b) kontaktiert ist.

3. Piezoaktor nach einem der Ansprüche 1 oder 2,
bei dem das Keramikmaterial des Schichtstapels (1) durch Sintern auf das vorgeformte Kontaktelement (5a, 5b, 5c, 5d, 9) aufgeschrumpft ist.

4. Piezoaktor nach einem der Ansprüche 2 bis 3,
bei dem der Stift (5a, 5b, 5c, 5d) gegenüber dem Grundkörper (4) unter Zugspannung steht.

5. Piezoaktor nach einem der Ansprüche 2 bis 4,
bei dem der Stift aus zwei halbrunden Teilstiften (5a, 5b) zusammengesetzt ist, die durch eine keramikhaltige Folie (6) voneinander getrennt sind.

6. Piezoaktor nach einem der Ansprüche 2 bis 5,
bei dem der Stift (5a, 5b, 5c, 5d) an seiner Oberfläche zu wenigstens 50 % ein Material aufweist, das dem Material der Elektrodenschichten (3a, 3b) entspricht.

7. Piezoaktor nach einem der Ansprüche 2 bis 6,
bei dem der Grundkörper (4) zwischen zwei Platten (7a, 7b) eingespannt ist, die an der Grund- und Deckfläche des Schichtstapels (1) angeordnet und am Stift (5a, 5b, 5c, 5d) befestigt sind.

8. Piezoaktor nach einem der Ansprüche 2 bis 7,
bei dem der Stift (5a, 5b, 5c, 5d) aus Metall besteht.

9. Piezoaktor nach einem der Ansprüche 2 bis 8,
bei dem der Stift (5a, 5b, 5c, 5d) miteinander verseilte Fasern enthält.

10. Verfahren zur Herstellung eines Piezoaktors nach einem der Ansprüche 1 bis 9, mit folgenden Schritten:
a) Bilden eines Schichtstapels (1) aus übereinanderliegenden keramischen Grünfolien (2) und Elektrodenschichten (3a, 3b)
b) Bohren eines Lochs in einen Schichtstapel (1)
c) Einschieben des vorgeformten Kontaktelements (5a, 5b, 5c, 5d, 9) in das Loch.

11. Verfahren nach Anspruch 10,
wobei der Schichtstapel (1) nach Einschieben des vorgeformten Kontaktelements (5a, 5b, 5c, 5d) in das Loch entkohlt und gesintert wird.

12. Verfahren nach einem der Ansprüche 10 oder 11,
wobei das Bohren des Lochs mittels eines Hartmetallbohrers erfolgt.

13. Verfahren nach einem der Ansprüche 10 bis 12,
wobei das vorgeformte Kontaktelement ein Stift (5a, 5b, 5c, 5d) ist, der zwei in Längsrichtung durch eine keramikhaltige Folie (6) getrennte Teilstifte (5a, 5b) enthält.

14. Verfahren nach einem der Ansprüche 10 bis 13,
wobei die Abmessung des Lochs (d_{L}) so an die Abmessungen (d_{S}) des vorgeformten Kontaktelements (5a, 5b, 5c, 5d) angepaßt werden, daß das Keramikmaterial aufgrund des Schwunds beim Sintern formschlüssig auf das vorgeformte Kontaktelement aufschrumpft.

15. Verfahren nach einem der Ansprüche 10 bis 13,
wobei die Abmessung des Lochs (d_{L}) so an die Abmessungen (d_{S}) des vorgeformten Kontaktelements (5a, 5b, 5c, 5d) angepaßt werden, daß aufgrund des Schwunds beim Sintern das Keramikmaterial kraftschlüssig auf das vorgeformte Kontaktelement aufschrumpft.

16. Verfahren nach einem der Ansprüche 10 bis 15,
wobei ein vorgeformtes Kontaktelement (5a, 5b, 5c, 5d) gewählt wird, dessen Wärmeausdehnungskoeffizient größer ist als der Wärmeausdehnungskoeffizient des gesinterten Keramikmaterials.

17. Piezoaktor nach einem der Ansprüche 1 bis 9,
bei dem ein vorgeformtes Kontaktelement (5a, 5b, 5c, 5d) eine innere Struktur aufweist.

18. Piezoaktor nach Anspruch 17,
bei dem ein vorgeformtes Kontaktelement (5a, 5b, 5c, 5d) eine Litze (9) umfaßt.

19. Piezoaktor nach einem der Ansprüche 17 oder 18,
bei dem ein vorgeformtes Kontaktelement (5a, 5b, 5c, 5d) miteinander verseilte Kupferdrähte aufweist.

20. Piezoaktor nach Anspruch 18,
bei dem ein Ende der Litze (9) mechanisch stabilisiert ist.

21. Piezoaktor nach Anspruch 18, 19 oder 20,
bei dem die Litze (9) an der Oberfläche eine metallhaltige Paste aufweist.

22. Piezoaktor nach einem der Ansprüche 18 bis 21,
bei dem die Litze (9) im Innern zur Verklebung von Drähten eine metallhaltige Paste aufweist.

23. Piezoaktor nach einem der Ansprüche 1 bis 9,
bei dem das Loch entlang einer Längsmittelachse des Grundkörpers (4) verläuft.

## Claims

1. Piezoactuator
- with a base body, which contains a stack (1) of superimposed piezoelectric layers (2) and electrode layers (3) lying in between, in which the piezoelectric layers (2) contain ceramic material and are sintered to one another,
- in which a hole passes through the base body (4) in the electrode layers (3a, 3b),
- pushed into which hole is a preformed contact element (5a, 5b, 5c, 5d, 9) for the contacting of the electrode layers (3a, 3b), **characterized in that**
- the contact element consists of a dimensionally stable material that does not undergo shrinkage during sintering.

2. Piezoactuator according to Claim 1, in which the preformed contact element is a pin (5a, 5b, 5c, 5d), which is in electrical contact with electrode layers (3a, 3b).

3. Piezoactuator according to either of Claims 1 and 2, in which the ceramic material of the layer stack (1) is shrunk on the preformed contact element (5a, 5b, 5c, 5d, 9) by sintering.

4. Piezoactuator according to either of Claims 2 and 3, in which the pin (5a, 5b, 5c, 5d) is under tensile stress with respect to the base body (4).

5. Piezoactuator according to one of Claims 2 to 4, in which the pin is made up of two half-round part-pins (5a, 5b), which are separated from each other by a ceramic-containing sheet (6).

6. Piezoactuator according to one of Claims 2 to 5, in which the pin (5a, 5b, 5c, 5d) comprises on at least 50% of its surface a material that corresponds to the material of the electrode layers (3a, 3b).

7. Piezoactuator according to one of Claims 2 to 6, in which the base body (4) is clamped between two plates (7a, 7b), which are arranged on the bottom and top faces of the layer stack (1) and are fastened to the pin (5a, 5b, 5c, 5d).

8. Piezoactuator according to one of Claims 2 to 7, in which the pin (5a, 5b, 5c, 5d) consists of metal.

9. Piezoactuator according to one of Claims 2 to 8, in which the pin (5a, 5b, 5c, 5d) contains twisted-together fibres.

10. Method for producing a piezoactuator according to one of Claims 1 to 9, with the following steps:
a) forming a layer stack (1) from superimposed ceramic green sheets (2) and electrode layers (3a, 3b)
b) drilling a hole in a layer stack (1)
c) pushing the preformed contact element (5a, 5b, 5c, 5d, 9) into the hole.

11. Method according to Claim 10, the layer stack (1) being decarburized and sintered after the preformed contact element (5a, 5b, 5c, 5d) has been pushed into the hole.

12. Method according to either of Claims 10 and 11, the drilling of the hole being performed by means of a hard metal drill.

13. Method according to one of Claims 10 to 12, the preformed contact element being a pin (5a, 5b, 5c, 5d), which contains two parts-pins (5a, 5b) separated in the longitudinal direction by a ceramic-containing sheet (6).

14. Method according to one of Claims 10 to 13, the dimension of the hole (d_{L}) being adapted to the dimensions (d_{S}) of the preformed contact element (5a, 5b, 5c, 5d) in such a way that the ceramic material shrinks onto the preformed contact element with positive engagement on account of the shrinkage during sintering.

15. Method according to one of Claims 10 to 13, the dimension of the hole (d_{L}) being adapted to the dimensions (d_{S}) of the preformed contact element (5a, 5b, 5c, 5d) in such a way that the ceramic material shrinks onto the preformed contact element with non-positive engagement on account of the shrinkage during sintering.

16. Method according to one of Claims 10 to 15, a preformed contact element (5a, 5b, 5c, 5d) that has a coefficient of thermal expansion greater than the coefficient of thermal expansion of the sintered ceramic material being chosen.

17. Piezoactuator according to one of Claims 1 to 9, in which the preformed contact element (5a, 5b, 5c, 5d) has an internal structure.

18. Piezoactuator according to Claim 17, in which a preformed contact element (5a, 5b, 5c, 5d) comprises a stranded wire (9).

19. Piezoactuator according to either of Claims 17 and 18, in which a preformed contact element (5a, 5b, 5c, 5d) has twisted-together copper wires.

20. Piezoactuator according to Claim 18, in which one end of the stranded wire (9) is mechanically stabilized.

21. Piezoactuator according to Claim 18, 19 or 20, in which the stranded wire (9) has a metal-containing paste on the surface.

22. Piezoactuator according to one of Claims 18 to 21, in which the stranded wire (9) has a metal-containing paste inside it for the adhesive bonding of wires.

23. Piezoactuator according to one of Claims 1 to 9, in which the hole runs along a longitudinal centre axis of the base body (4).

## Revendications

1. Actionneur piézoélectrique
- comprenant un corps de base, qui comporte une pile (1) de couches (2) piézoélectriques superposées et des couches (3) d'électrodes interposées entre elles, dans lequel les couches (2) piézoélectriques contiennent de la matière céramique et sont frittées entre elles,
- dans lequel un trou traverse le corps (4) de base dans les couches (3a, 3b) d'électrodes,
- dans lequel un élément (5a, 5b, 5c, 5d, 9) de contact préformé est inséré pour la mise en contact des couches (3a, 3b) d'électrodes, **caractérisé en ce que**
- l'élément de contact est en un matériau de forme stable qui n'a pas de retrait au frittage.

2. Actionneur piézoélectrique suivant la revendication 1,
dans lequel l'élément de contact préformé est une tige (5a, 5b, 5c, 5d) qui est mise en contact avec des couches (3a, 3b) d'électrodes.

3. Actionneur piézoélectrique suivant l'une des revendications 1 ou 2,
dans lequel la matière céramique de la pile (1) de couches est rétreinte par frittage sur l'élément (5a, 5b, 5c, 5d, 9) de contact préformé.

4. Actionneur piézoélectrique suivant l'une des revendications 2 à 3,
dans lequel la tige (5a, 5b, 5c, 5d) est sous contrainte de traction par rapport au corps (4) de base.

5. Actionneur piézoélectrique suivant l'une des revendications 2 à 4,
dans lequel la tige est composée de deux sous-tiges (5a, 5b) demi-rondes qui sont séparées l'une de l'autre par une feuille (6) contenant de la céramique.

6. Actionneur piézoélectrique suivant l'une des revendications 2 à 5,
dans lequel la tige (5a, 5b, 5c, 5d) a sur sa surface au moins 50 % d'une matière qui correspond à la matière des couches (3a, 3b) d'électrodes.

7. Actionneur piézoélectrique suivant l'une des revendications 2 à 6,
dans lequel le corps (4) de base est encastré entre deux plaques (7a, 7b) qui sont disposées sur la surface de base et la surface de sommet de la pile (3) de couches et qui sont fixées à la tige (5a, 5b, 5c, 5d).

8. Actionneur piézoélectrique suivant l'une des revendications 2 à 7,
dans lequel la tige (5a, 5b, 5c, 5d) est en métal.

9. Actionneur piézoélectrique suivant l'une des revendications 2 à 8,
dans lequel la tige (5a, 5b, 5c, 5d) contient des fibres câblées entre elles.

10. Procédé de fabrication d'un actionneur piézoélectrique suivant l'une des revendications 1 à 9, comprenant les stades suivants :
a) on forme une pile (1) de couches composées de feuilles (2) superposées en céramique crue et de couches (3a, 3b) d'électrodes,
b) on perce un trou dans une pile (1) de couches,
c) on introduit l'élément (5a, 5b, 5c, 5d, 9) de contact préformé dans le trou.

11. Procédé suivant la revendication 10,
dans lequel on décarbure la pile (1) de couches après insertion de l'élément (5a, 5b, 5c, 5d) de contact préformé dans le trou et on la fritte.

12. Procédé suivant l'une des revendications 10 ou 11,
dans lequel on effectue le perçage des trous au moyen d'un foret en métal dur.

13. Procédé suivant l'une des revendications 10 à 12,
dans lequel l'élément de contact préformé est une tige (5a, 5b, 5c, 5d) qui comporte deux sous-tiges (5a, 5b) séparées dans la direction longitudinale par une feuille (6) contenant de la céramique.

14. Procédé suivant l'une des revendications 10 à 13,
dans lequel la dimension du trou (d_{L}) est adaptée aux dimensions (d_{S}) de l'élément (5a, 5b, 5c, 5d) de contact préformé de façon à ce qu'en raison du retrait au frittage la matière céramique se rétrécisse à complémentarité de formes sur l'élément de contact préformé.

15. Procédé suivant l'une des revendications 10 à 13,
dans lequel la dimension du trou (d_{L}) est adaptée aux dimensions (d_{S}) de l'élément (5a, 5b, 5c, 5d) de contact préformé de manière en ce qu'en raison du retrait au frittage la matière céramique se rétrécisse à complémentarité de forces sur l'élément de contact préformé.

16. Procédé suivant l'une des revendications 10 à 15,
dans lequel on choisit un élément (5a, 5b, 5c, 5d) de contact préformé dont le coefficient de dilatation thermique est plus grand que le coefficient de dilatation thermique de la matière céramique frittée.

17. Actionneur piézoélectrique suivant l'une des revendications 1 à 9,
dans lequel un élément (5a, 5b, 5c, 5d) de contact préformé a une structure intérieure.

18. Actionneur piézoélectrique suivant la revendication 17,
dans lequel un élément (5a, 5b, 5c, 5d) de contact préformé comprend une tresse (9).

19. Actionneur piézoélectrique suivant l'une des revendications 17 ou 18,
dans lequel un élément (5a, 5b, 5c, 5d) de contact préformé a des fils de cuivre toronnés les uns avec les autres.

20. Actionneur piézoélectrique suivant la revendication 18,
dans lequel une extrémité de la tresse (9) est stabilisée mécaniquement.

21. Actionneur piézoélectrique suivant la revendication 18, 19 ou 20,
dans lequel la tresse (9) a sur la surface une pâte contenant du métal.

22. Actionneur piézoélectrique suivant l'une des revendications 18 à 21,
dans lequel la tresse (9) a à l'intérieur une pâte contenant du métal pour le collage des fils.

23. Actionneur piézoélectrique suivant l'une des revendications 1 à 9,
dans lequel le trou s'étend le long d'un axe médian longitudinal du corps (4) de base.
